# EUROPEAN PATENT APPLICATION

(11) **EP 1 509 070 A2**
(43) Date of publication of application: **23.02.2005**
(21) Application number: 04019002.7
(22) Date of filing: 11.08.2004
(51) Int. Cl.: H05K 3/20

(54) **Method for producing an electrical conductor element and electrical conductor element**

(30) Priority: 22.08.2003 EP 03019030
(71) Applicant: Tyco Electronics Nederland B.V., 5222 AR 's-Hertogenbosch (NL)
(72) Inventor: Den Otter, Johannes Marinus Jacobus, 5244 GK Rosmalen (NL)
(74) Representative: Patentanwaltskanzlei WILHELM & BECK

(57) **Abstract**

The present invention relates to a method for producing an electrical conductor element with a housing (15) and a conductor (13), whereby the housing (15) is made by a moulding process and the conductor (13) is embedded in the housing (15), whereby the conductor (13) is produced by an electroforming process on a metallic layer (10). The conductor (13) and the metallic layer (10) are covered with the housing (15) by a moulding process, and the metallic layer (10) is removed from the conductor (13) and the moulded housing (15). This method advantageously combines the well known moulding process and the well known electroforming process for providing a reliable process for producing an electrical conductor element.

## Description

Method for producing an electrical conductor element and electrical conductor element

The invention pertains to a method of producing an electrical conductor element according to the preamble of claim 1 and to an electrical conductor element produced by a moulding process.

Using the three-dimensional injection-moulded process, it is possible to produce a three-dimensional injection-moulded conductor support in which conducting tracks are embedded directly into a three-dimensional housing. By this method several layers of tracks can be encapsulated within the housing. The conductor tracks may be arranged on the surface of the housing which extend into three spatial directions.

An electrical conductor element can, however, be produced by manufacturing a plastic foil, depositing a conductor track on the plastic foil, for example by a screen-printing process. Subsequently, the plastic foil is thermoformed and the backside of the thermoformed foil is over-moulded by a thicker layer providing the stability for a three-dimensional connection element.

Furthermore, it is known in the state of the art to deposit a circuit structure on a carrier film. A work piece is produced on the carrier film by a moulding process. After the moulding process, the carrier film is removed from the work piece. The work piece with the circuit structure constitutes an electrical conductor element with a housing.

Furthermore, it is well-known in the state of the art to produce a conducting track by an electroplating or an electroforming process.

The European patent application EP 1 246 308 A2 describes a pair of electrical conductors using resin solder in one conductor. The electrical conductor comprises a first housing which is made of a synthetic resin and a first terminal which has a contacting part and a connecting part, both being exposed on the surface of the first housing. A second electrical conductor comprises a second housing which is made of an insulating material, and a second terminal which is made of a conductive material of which the elasticity is higher than of the material of the first conductor.

The US patent 4,147,740 describes a structural process for fabricating conductive patterns having sub-half micron dimensions. A mask and a lithographic process is disclosed for the formation of conductive patterns on substrates, particularly connection with the formation of high-electromobility transistors and metal semiconductor field effect transistors. The technique allows the formation of sub-half micron conductive patterns on semiconductor substrates using optical lithography and a multilayer portable conformable mask. The method includes the application of optical contact lithography to a conventional photo-resist followed by a deep UV-flood exposure of an underlying multilayer portion. Metal is deposited on a semiconductor substrate through the mask formed by the photo-resist and the underlying multilayer to produce sub-half micron conductive patterns.

The US patent 6,218,203 B1 describes a method of producing a contact structure for achieving an electrical connection with a contact target. The contact structure includes a contactor formed on a planar surface of a substrate by means of a micro-fabrication technology. In one aspect, the production method involves a plastic moulding technology. In another aspect, the production method involves a photolithography technology using a grey-tone photomask. The contactor has at least a horizontal portion formed on the substrate and a contact portion formed on one end of the horizontal portion. A spring force of the horizontal portion of the contactor provides a contact force when the contactor is pressed against the contact target. In a further aspect, the contact structure includes a recess for providing a free space for the contactor when the contactor is pressed against the contact target.

The US patent application publication US 2002/0031905 A1 describes a method of producing a connection component. The method provides a movable layer having first and second surfaces and forming vias at spaced-apart first locations of a removable layer. A conductive material, such as copper, is deposited over the first surface of the removable layer and in each of the vias to form one or more flexible leads including projections which downwardly extend to the wires towards the removable layer. Each lead includes a first end integrally connected to one of the projections and a second end. A substrate is provided over the conductive material. The removable layer is removed so that the first and the second ends of the leads can be moved away from each other. As a result, at least first or second ends of the leads are connected to the substrate without using a bonding or welding step.

It is an object of the invention to provide a simple and cheap method of producing an electrical conductor element. The object of the invention is achieved by the method according to claim 1 and the electrical conductor element according to claim 9.

Further embodiments of the invention are disclosed in the dependent claims.

An advantage of the invention is to use a combination of the electroforming process and the moulding process to produce an electrical conductor element with an embedded conductor. The advantage of the method according to claim 1 is that the two processes are well-known and could be advantageously combined to a new process which allows for a cheap and reliable production for an electrical conductor element with an embedded conductor.

In a preferred embodiment of the process, the metallic layer is covered with a photo-resist layer. The photo-resist layer is structured with a pattern of the conductor. The structured photo-resist layer is used as a mask for forming a conductor by an electroforming process of the metallic layer. Using the photo-resist layer as a mask for the electroforming process results in a simple and cheap process.

After forming the conductor by means of the electroforming process, the photo-resist layer is removed and the conductor element and the surface of the metallic layer is covered with a moulding material by a moulding process. After moulding the housing, the metallic layer is removed by an etching process.

In a preferred embodiment of the invention, the conductor is formed with a smaller face upon the metallic layer and with a broader face with a shoulder upon the photo-resist layer.

This shape has the advantage that the conductor is assuredly affixed in the housing by the shoulder.

In a preferred embodiment of the invention, the metallic layer is made of an aluminium foil.

Preferably, a second layer made of gold and nickel is deposited on the metallic layer and the conductor element is made of copper and deposited on the second layer. This layer structure results in a good depositing behaviour of the copper forming the conductor and the metallic layer.

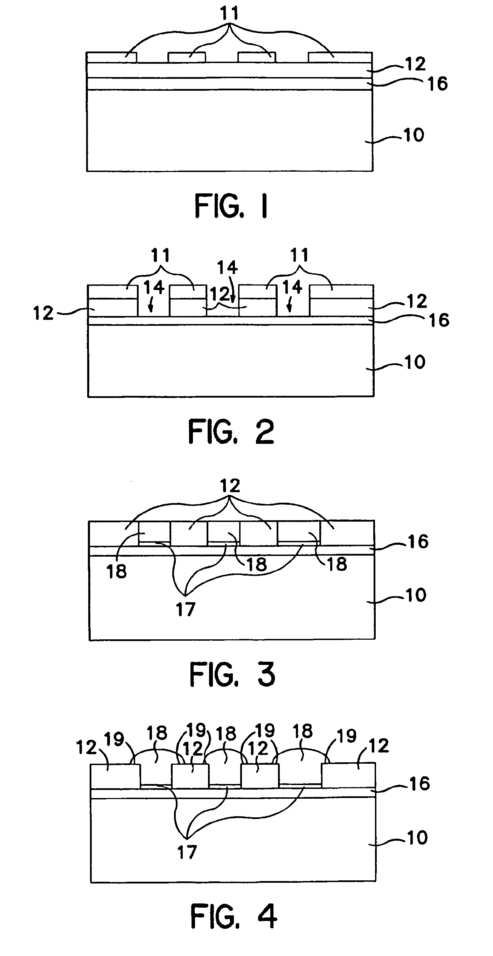

The invention is explained in the following Figures:. The Figures 1 to 8 show different steps of the production process for producing an electrical connection element with a housing and a conductor embedded therein.

Fig. 1 shows a sectional view of a metallic layer 10 that is covered with a top layer 16. As a metallic layer 12, an aluminium foil is preferably used. The thickness of the aluminium foil may very between 50 and 100µm. The top layer 16 may be a copper layer with a thickness between 1 and 10µm. On the top layer 16 a photo-resist layer 12 is deposited. The photo-resist layer 12 is covered with a photomask layer 11. The photo-resist layer 12 is structured using the photomask layer 11 according to a pattern of a conductor. For this purpose, the photo-resist layer 12 is removed in the given pattern from the metallic layer 10 as shown in Fig. 2. Recesses 14 of the photo-resist layer 12 have the shape of the conductor 13. Then the photomask layer 11 is removed from the photo-resist layer 12.

After this step, a starting layer 17 made of nickel is deposited by an electroforming process on the free surface of the top layer 16. The starting layer may have a thickness of about 2 to 8µm. Then a filling layer 18 is deposited on the starting layer 17 by means of an electroforming process. The filling layer 18 may be made of copper and have a plane end face to the photo-resist layer 12. The starting layer 17 and the filling layer 18 constitute the conductor 13 that are shaped as tracks. This is shown in Fig. 3. In a preferred embodiment of the invention, the metallic layer of the tracks is made for example of an aluminium or copper or a combination of a aluminium/copper layer.

In a preferred embodiment, the filling layer 18 is deposited with shoulders 19 that are arranged on the surface of the photo-resist layer 12. The filling layer 18 shows a shape of a mushroom in the cross-sectional view as shown in Figure 4.

The filling layer 18 is deposited in the recesses 14 of the photo-resist layer 12. By depositing, material is also deposited onto the surface of the photo-resist layer 12 at the border of the recesses 14. Therefore, shoulders 19 of the conductor 13 are arranged on the photo-resist layer 12.

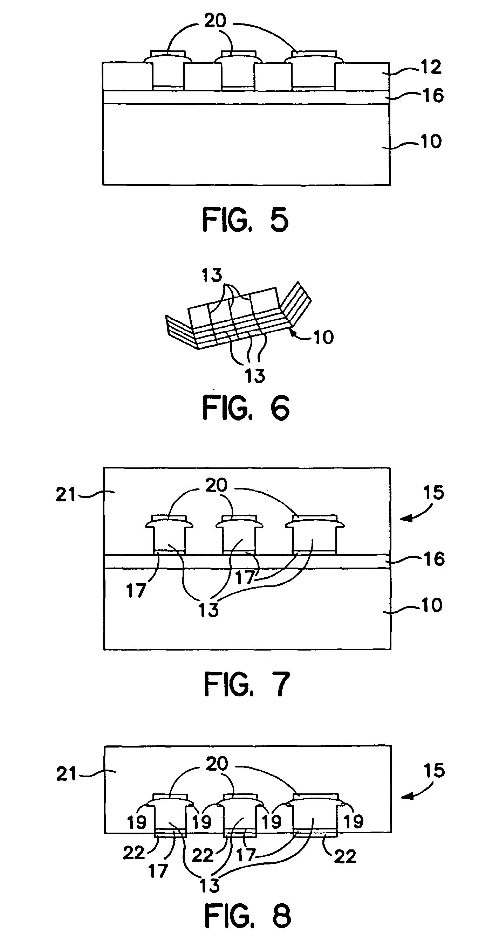

In a preferred embodiment of the invention, a second top layer 20 is deposited on the top of the filling layer 18. The second top layer 20 is made of an alloy of nickel and gold by a plating process or is made of a tin layer produced by an immersion process. This status is depicted in Figure 5.

In a preferred embodiment of the invention, the metallic layer with the conductors 13 constitutes a flexible circuit film. The flexible circuit film may be cut and/or formed in three spatial directions, as shown in Figure 6.

After this, the photo-resist layer 12 is removed for example by an etching process and the conductors 13 and the free surfaces of the metallic layer 10 are covered by a moulding process with a moulding material 21. As a moulding material for example a plastic compound may be used. The moulding material constitutes a housing 15 in which the connectors 13 are embedded This process step is shown in Fig. 7.

Afterwards, the metallic layer 10 is removed from the conductors 13 and the top layer 16 is removed by an etching process. In a following step, the top layer 16 is removed and the starting layer 17 is covered with a third top layer 22. The third top layer 22 is produced by the same process and the same material as the second top layer 20. This process status is shown in Fig. 8. The housing could have the shape of a small plate so that the housing constitutes an electrically isolated layer that could be formed by a subsequent forming process to create a three-dimensional moulded interconnect device. The process could be used for producing an electrical conductor element, for example a coaxial conductor for mobile phones. The coax conductor could be used as a switching coax conductor for mobile phones used for testing and for car kit applications. The switching function of the coax conductor may be used for transmitting the signal from an internal phone antenna of the mobile phone to an external car antenna.

### Reference list

- 10: metallic layer
- 11: photomask layer
- 12: photoresist layer
- 13: connector
- 14: recess
- 15: housing
- 16: top layer
- 17: starting layer
- 18: filling layer
- 19: shoulder
- 20: second top layer
- 21: moulding material
- 22: third top layer

## Claims

1. Method for producing an electrical conductor element with a housing (15) and a conductor (13), whereby the housing (15) is made by a moulding process and the conductor (13) is embedded in the housing (15), whereby the conductor (13) is produced by an electroforming process on a metallic layer (10), **characterised in that** the conductor (13) and the metallic layer (10) are covered with the housing (15) by a moulding process, and that the metallic layer (10) is removed from the conductor (13) and the housing (15).

2. Method according to claim 1, **characterised in that** the metallic layer (10) is covered with a photo-resist layer (12) that a pattern of the conductor (13) is removed from the photo resist layer (12), that the structured photo resist layer (12) is used as a mask for depositing the conductor (13) by the electroforming process on the metallic layer (10).

3. Method according to claim 1 or 2, **characterised in that** the photo-resist (12) layer is removed from the surface of the metallic layer (10) that the conductor (13) and the surface of the metallic layer (10) is covered with plastic material by a moulding process and that the metallic layer (10) is removed by an etching process.

4. Method according to one of the claims 1 to 3, **characterised in that** the conductor (13) is deposited in recesses (14) of the photo resist layer (12) and with a shoulder (19) upon the photo resist layer (12).

5. Method according to any one of the claims 1 to 4, **characterised in that** the metallic layer (10) is made of an aluminium foil.

6. Method according to any one of the claims 1 to 5, **characterised in that** a top layer (16) is deposited on the metallic layer (10) before the electroforming process.

7. Method according to any one of the claims 1 to 6, **characterised in that** a metallic starting layer (17) is produced by the electroforming process and that on the starting layer (17) a filling layer (18) is deposited for producing the conductor (13).

8. Method according to any one of the claims 1 to 7, **characterized in that** on the top and/or on the bottom of the conductor (13) a second or a third top layer (20, 22), respectively, is deposited.

9. Electrical conductor element with a housing (15) and a conductor (13), whereby the housing (15) is made by a moulding process and the conductor (13) is embedded in the housing (15), whereby the electrical conductor element is produced by a process according to claim 1.
